# EUROPÄISCHE PATENTSCHRIFT

(11) **EP 1 927 892 B1**
(45) Veröffentlichungstag und Bekanntmachung des Hinweises auf die Patenterteilung: **15.12.2010**
(21) Anmeldenummer: 07020745.1
(22) Anmeldetag: 24.10.2007
(51) Int. Cl.: G03F 7/20

(54) **Beleuchtungsoptik für die EUV-Projektions-Mikrolithographie, Projektionsbelichtungsanlage und Verfahren zur Herstellung eines mikrostrukturierten Bauteils**
Illumination lens for an EUV projection microlithography, projection exposure apparatus and method for manufacturing microstructured component
Optique d'éclairage pour la microlithographie de projection EUV, installation d'exposition par projection microlithographique et procédé de fabrication d'un composant microstructuré

(30) Priorität: 28.11.2006 DE 102006056035
(43) Veröffentlichungstag der Anmeldung: 04.06.2008
(73) Patentinhaber: Carl Zeiss SMT AG, 73447 Oberkochen (DE)
(72) Erfinder: Warm, Berndt, 90571 Schwaig (DE); Dengel, Günther, 89518 Heidenheim (DE)
(74) Vertreter: Hofmann, Matthias

(56) Entgegenhaltungen:
- WO-A-03/050586
- WO-A1-01/09684
- DE-A1- 10 205 425
- US-A1- 2005 111 067
- US-A1- 2006 103 908

## Beschreibung

Die Erfindung betrifft eine Beleuchtungsoptik für die EUV-Projektions-Mikrolithographie. Ferner betrifft die Erfindung ein Beleuchtungssystem mit einer derartigen Beleuchtungsoptik, eine Projektionsbelichtungsanlage mit einem derartigen Beleuchtungssystem und ein Verfahren zur Herstellung eines mikrostrukturierten Bauteils.

Eine Projektionsbelichtungsanlage der eingangs genannten Art ist aus der US 6,658,084 B2 bekannt. Dort kann durch Verkippung einzelner Feldfacetten zwischen verschiedenen Beleuchtungssettings gewechselt werden. Der konstruktive Aufwand zur Realisierung eines derart verstellbaren Feldfacettenspiegels ist enorm hoch.

Facettenspiegel mit einer Mehrzahl einzelner Facetten, die lösbar mit einer Tragplatte verbunden sind, sind für den Einsatz in der mikrolithographischen Projektionsbelichtung bekannt aus der US 2005/0111067 A1, der DE 102 05 425 A1 und der WO 03/050586 A2. Ein Spiegel mit aktiven Facetten ist zum Einsatz bei der mikrolithographischen Projektionsbelichtung bekannt aus der US 2006/0103908 A1.

WO 01/09684 A1 offenbart eine Projektionsbelichtungsanlage mit Facettenspiegeln wobei der Feldfacettenspiegel zur Veränderung der Ausleuchtung der Austrittspupille austauschbar ist.

Es ist daher eine Aufgabe der vorliegenden Erfindung, eine Beleuchtungsoptik der eingangs genannten Art derart weiterzubilden, dass ein Wechsel zwischen verschiedenen Beleuchtungssettings mit geringerem konstruktiven Aufwand möglich ist.

Diese Aufgabe ist erfindungsgemäß gelöst durch die im Kennzeichnungsteil des Anspruchs 1 angegebenen Merkmale.

Erfindungsgemäß wurde erkannt, dass es zur Vorgabe verschiedener Beleuchtungssettings möglich ist, einzelne Untereinheiten des Facetten-Spiegels gegen andere Untereinheiten, die zu anderen Beleuchtungsverhältnissen führen, auszutauschen. In der Praxis werden die Beleuchtungsverhältnisse so geändert, dass die Beleuchtung des Beleuchtungsfeldes, also die Verteilung der Beleuchtungswinkel (Beleuchtungssetting), mit denen Feldpunkte ausgeleuchtet werden, geändert wird. Die Ausleuchtung des Beleuchtungsfeldes, also dessen ausgeleuchtete Fläche, bleibt in der Praxis oft unverändert. Durch den blockweisen Austausch von Untereinheiten des Facetten-Spiegels kann eine mechanische Lösung zum Beleuchtungssetting-Wechsel realisiert werden, die konstruktiv einen wesentlich geringeren Aufwand bedeutet, als eine Einzelverkippung von Facetten. Auch die in vielen Fällen notwendige Kühlung des Facetten-Spiegels lässt sich unter Beibehaltung der Auswechselbarkeit der Untereinheiten gewährleisten. Beleuchtungssettingänderungen lassen sich mit wenigen Stelleinheiten der Wechseleinrichtung realisieren. Gruppen von Facetten, insbesondere Facetten-Gruppen, die eine größere Anzahl einzelner Facetten aufweisen, bleiben mechanisch miteinander verbunden, wobei eine effiziente Kühlung der Facetten möglich ist. Durch die erfindungsgemäße Beleuchtungsoptik lässt sich abhängig von den Anforderungen, die beispielsweise an den Durchsatz oder an die Strukturauflösung einer Projektionsbelichtungsanlage gestellt werden, jeweils ein diesen Anforderungen entsprechendes Beleuchtungssetting vorgeben.

Bei einer Beleuchtungsoptik nach Anspruch 2 kann mit einem Austausch einzelner Untereinheiten des Feldfacetten-Spiegels gegen andere Untereinheiten eine geänderte Beleuchtung des Pupillenfacetten-Spiegels herbeigeführt werden, was zu einem entsprechend geänderten Beleuchtungssetting führt. Der Facetten-Spiegel, dessen Untereinheiten austauschbar sind, ist bei dieser Variante der Feldfacetten-Spiegel. Der Pupillenfacetten-Spiegel muss nicht genau am Ort der erzeugten sekundären Lichtquellen angeordnet sein. Alternativ ist es möglich, die Pupillenfacetten des Pupillenfacetten-Spiegels definiert vom Ort der sekundären Lichtquellen zu beabstanden, wie dies beispielsweise in der US 6,611,574 B2 beschrieben ist.

Bei der Beleuchtungsoptik kann es sich auch um eine solche handeln, bei der die sekundären Lichtquellen sagittal und tangential in zueinander beabstandeten Ebenen erzeugt werden. Eine derartige Anordnung ist aus der US 6,507,440 B1 bekannt.

Schließlich kann die Beleuchtungsoptik auch einen einzigen Facetten-Spiegel aufweisen, wobei dieser einzige Facetten-Spiegel austauschbare Untereinheiten aufweist. Der einzige Facetten-Spiegel sorgt gleichzeitig für eine definierte Be- und Ausleuchtung des Beleuchtungsfeldes. Ein entsprechender Facetten-Spiegel ist in der EP 1 024 408 A2 beschrieben.

Eine Feldfacetten-Ausrichtung nach Anspruch 3 ermöglicht durch Austausch von Untereinheiten des Feldfacetten-Spiegels einen Wechsel zwischen prinzipiellen Settings, z. B. einen Wechsel zwischen einem konventionellen und einem annularen Setting. Ein derartiger Wechsel zwischen prinzipiellen Settings wäre nicht möglich, wenn jede Untereinheit des Feldfacetten-Spiegels Pupillenfacetten beleuchtet, die über die gesamte Apertur des Pupillenfacetten-Spiegels verteilt sind.

Eine Wechseleinrichtung nach Anspruch 4 lässt sich mit unaufwändiger Antriebstechnik gestalten.

Ein Schwenkantrieb nach Anspruch 5 ermöglicht die Vorgabe mehrerer auswechselbarer Untereinheiten, wobei die Wechseleinrichtung geringen Bauraum einnimmt.

Bei einer Lage der Schwenkachse nach Anspruch 6 kann die Wechseleinrichtung kompakt in der Nähe des, insbesondere hinter dem Feldfacetten-Spiegel angeordnet werden.

Eine Kühlungsanordnung mit einem längs der Schwenkachse verlaufenden Leitungsabschnitt nach Anspruch 7 vermeidet Probleme bei der Kühlleitungs-Führung im Zusammenhang mit dem Verschwenken der Wechseleinrichtung. Das Kühlsystem mit einer derartigen Kühlungsanordnung kann insbesondere in sich geschlossen ausgeführt werden.

Flexible Leitungsabschnitte nach Anspruch 8 erlauben eine Verlagerung des Grundkörpers der Wechsel-Untereinheiten zwischen der Spiegel- und der Neutralposition bei geringem konstruktiven Aufwand.

Ein Positionierantrieb nach Anspruch 9 ist baulich einfach ausführbar.

Gestaltungen der Wechseleinrichtungen nach den Ansprüchen 10 und 11 gewährleisten eine exakte Lage- und Winkelpositionierung der Untereinheit in der Spiegelposition.

Nicht auswechselbare Untereinheiten nach Anspruch 12 können Teilbereiche des Pupillenfacetten-Spiegels ausleuchten, die bei jedem einzustellenden Beleuchtungssetting ausgeleuchtet werden müssen, und / oder das Beleuchtungsfeld in immer gleicher Weise be- und ausleuchten. Dies vereinfacht den Aufbau der Beleuchtungsoptik.

Teilbereich-Beleuchtungen der auswechselbaren Untereinheiten nach den Ansprüchen 13 bis 19 haben sich zur Vorgabe verschiedener Beleuchtungssettings als besonders geeignet herausgestellt. Entsprechende Teilbereich-Beleuchtungen können auch bei Ausführungen der Beleuchtungsoptik eingesetzt werden, bei denen eine Erzeugung sekundärer Lichtquellen sagittal und tangential in zueinander beabstandeten Ebenen stattfindet oder bei denen ein einziger Facetten-Spiegel mit austauschbaren Untereinheiten vorgesehen ist. Im letzteren Fall werden durch Austausch der Untereinheiten entsprechende Teilbereiche des Beleuchtungsfeldes in unterschiedlicher Weise be- und ausgeleuchtet.

Weitere Aufgaben der Erfindung sind, ein Beleuchtungssystem mit der erfindungsgemäßen Beleuchtungsoptik, eine Projektionsbelichtungsanlage mit dem erfindungsgemäßen Beleuchtungssystem sowie ein Verfahren zur Herstellung eines mikrostrukturierten Bauteils unter Verwendung der erfindungsgemäßen Projektionsbelichtungsanlage anzugeben.

Diese Aufgaben sind erfindungsgemäß gelöst durch ein Beleuchtungssystem nach Anspruch 20, eine Projektionsbelichtungsanlage nach Anspruch 21 und ein Herstellungsverfahren nach den Ansprüchen 22 bis 24.

Die Vorteile dieser Gegenstände entsprechen denjenigen, die vorstehend schon unter Bezugnahme auf die Beleuchtungsoptik nach den Ansprüchen 1 bis 19 diskutiert wurden.

Ausführungsbeispiele der Erfindung werden nachfolgend anhand der Zeichnung näher erläutert. In dieser zeigen:
- Fig. 1: schematisch eine Projektionsbelichtungsanlage für die EUV- Projektions-Mikrolithographie in einem Meridionalschnitt;
- Fig. 2: eine Aufsicht auf ein Ausführungsbeispiel eines Feldfacetten- Spiegels, der unterteilt ist in eine Feldfacetten-Gruppen auf- weisende stationäre Untereinheit und eine Feldfacetten- Gruppen aufweisende Wechsel-Untereinheit;
- Fig. 3: schematisch eine Aufsicht auf einen Pupillenfacetten-Spiegel, bei dem die von einer Feldfacetten-Gruppe der Wechsel-Untereinheit des Feldfacetten-Spiegels nach Fig. 2 beleuchte ten Pupillenfacetten durch eine Schraffur hervorgehoben sind;
- Fig. 4: schematisch Pupillenfacetten des Pupillenfacetten-Spiegels, die von der stationären Untereinheit und der Wechsel-Untereinheit des Feldfacetten-Spiegels nach Fig. 2 beleuchtet sind;
- Fig. 5: schematisch Pupillenfacetten des Pupillenfacetten-Spiegels nach Fig. 4, die vom Feldfacetten-Spiegel nach Fig. 2 nach Auswechselung der Wechsel-Untereinheit gegen eine weitere Wechsel-Untereinheit beleuchtet sind;
- Fig. 6: schematisch eine Aufsicht auf einen weiteren Feldfacetten-Spiegel mit einer stationären Untereinheit und zwei Wechsel-Untereinheiten;
- Fig. 7: in einer Aufsicht eine Wechseleinrichtung zum Austausch mindestens einer der beiden Wechsel-Untereinheiten des Feldfacetten-Spiegels nach Fig. 6 gegen andere Wechsel-Untereinheiten, wobei die Wechseleinrichtung insgesamt vier Wechsel-Untereinheiten aufweist;
- Fig. 8: schematisch einen Ausschnitt der Wechseleinrichtung nach Fig. 7 mit einem Positionierantrieb zur Positionier-Verlagerung eines Grundkörpers einer der Wechsel-Untereinheiten zwischen einer Spiegelposition und einer Neutralposition;
- Fig. 9: schematisch den Grundkörper einer Wechsel-Untereinheit vor dem Einsetzen in die Spiegelposition im Feldfacetten-Spiegel;
- Fig. 10: Pupillen-Facettenspiegel mit verschieden hervorgehobenen und von den Untereinheiten des Feldfacetten-Spiegels nach Fig. 6 beleuchtbaren, jeweils eine Mehrzahl von Pupillenfacetten aufweisenden Teilbereichen;
- Fig. 11: eine weitere Ausführung eines Feldfacetten-Spiegels mit einer stationären Untereinheit und zwei Wechsel-Untereinheiten in einer zu Fig. 6 ähnlichen Darstellung;
- Fig. 12: in einer zu Fig. 7 ähnlichen Darstellung eine Wechseleinrichtung, die vier Wechsel-Untereinheiten für den Feldfacetten-Spiegel nach Fig. 11 aufweist;
- Fig. 13: schematisch die Ausleuchtung eines Pupillenfacetten-Spiegels durch den Feldfacetten-Spiegel nach Fig. 11, wobei letzterer in einer ersten Konfiguration aus stationärer Untereinheit und zwei Wechsel-Untereinheiten vorliegt;
- Fig. 14: schematisch die Ausleuchtung eines Pupillenfacetten-Spiegels durch den Feldfacetten-Spiegel nach Fig. 11, wobei letzterer in einer weiteren Konfiguration aus stationärer Untereinheit und zwei Wechsel-Untereinheiten vorliegt;
- Fig. 15: schematisch eine weitere Ausführung eines Feldfacetten-Spiegels mit einer stationären Untereinheit und zwei Wechsel-Untereinheiten; und
- Fig. 16: in einer zur Fig. 7 ähnlichen Darstellung eine Wechseleinrichtung für die Wechsel-Untereinheiten des Feldfacetten-Spiegels nach Fig. 15, wobei die Wechseleinrichtung nach Fig. 16 vier Wechsel-Untereinheiten umfasst.

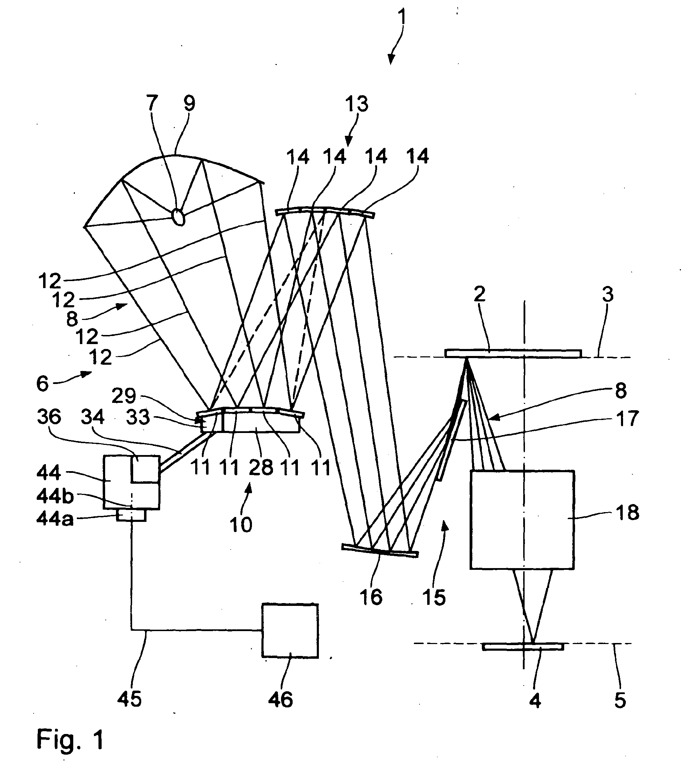

Fig. 1 zeigt schematisch eine Projektionsbelichtungsanlage 1 für die EUV-Projektions-Mikrolithographie. Mit der Projektionsbelichtungsanlage 1 wird eine Struktur auf einem Retikel 2, die in einer Retikelebene 3 vorliegt, abgebildet auf eine lichtempfindliche Schicht eines Wafers 4 in einer Waferebene 5.

Zur Beleuchtung eines Beleuchtungsfeldes in der Retikelebene 3 dient eine insgesamt mit 6 bezeichnete Beleuchtungsoptik. Zusammen mit einer EUV-Lichtquelle 7 stellt die Beleuchtungsoptik 6 ein Beleuchtungssystem der Projektionsbelichtungsanlage 1 dar.

EUV-Strahlung 8, die von der EUV-Lichtquelle 7 emittiert wird, wird zunächst von einem Kollektor 9, der in der Fig. 1 schematisch dargestellt ist, gesammelt. Das kollimierte EUV-Strahlungsbündel trifft dann auf einen Feldfacetten-Spiegel 10 mit einer Mehrzahl schematisch angedeuteter Feldfacetten 11. Die Feldfacetten 11 dienen zur Erzeugung von sekundären Lichtquellen. Die Feldfacetten 11 sind jeweils Teilbündeln 12 der EUV-Strahlung 8 zugeordnet.

Am Ort der vom Feldfacetten-Spiegel 10 erzeugten sekundären Lichtquellen ist ein Pupillenfacetten-Spiegel 13 angeordnet. Dieser hat eine Mehrzahl von in der Fig. 1 schematisch angedeuteten Pupillenfacetten 14, die über die ihnen zugeordneten Feldfacetten 11 mit den EUV-Teilbündeln 12 beaufschlagt werden.

Der Pupillenfacetten-Spiegel 13 ist Teil einer optischen Einrichtung 15, die den Feldfacetten-Spiegel 10 in die Retikelebene 3 abbildet. Zu der optischen Einrichtung 15 gehören zwei abbildende Spiegel 16, 17.

Der Aufbau des Beleuchtungssystems ist in der Fig. 1 schematisch dargestellt und dient der Veranschaulichung der Funktion des Feldfacetten-Spiegels 10 und des Pupillenfacetten-Spiegels 13. Der Kollektor 9 und die optische Einrichtung 15 können auch anders angeordnet und aus anders geformten Komponenten sowie anderen Anzahlen von Komponenten aufgebaut sein.

Vom Retikel 2 reflektierte EUV-Strahlung 8 wird von einer schematisch angedeuteten Projektionsoptik 18 in ein Bildfeld in der Waferebene 5 abgebildet.

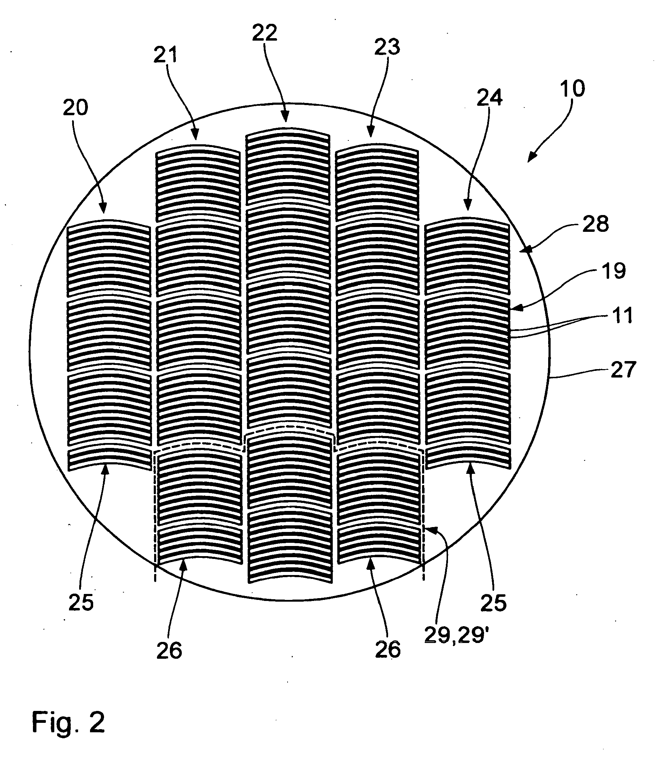

Der Feldfacetten-Spiegel 10 ist in der Fig. 2 in einer Aufsicht dargestellt. Die einzelnen Feldfacetten 11 sind bogenförmig. Auch gerade, also rechteckig aufgebaute, Feldfacetten sind möglich. Die Feldfacetten 11 sind in Gruppen 19 zu je zehn Feldfacetten 11 angeordnet. Die Feldfacetten-Gruppen 19 sind wiederum spaltenweise in fünf Feldfacetten-Spalten 20, 21, 22, 23 und 24 angeordnet, die in der Fig. 2 von links nach rechts durchnumeriert sind. Die Spalten 20 und 24 haben drei Feldfacetten-Gruppen zu je zehn Feldfacetten 11 und jeweils eine in der Fig. 2 unten dargestellte Restgruppe 25 zu je drei Feldfacetten 11. Die Spalten 21 und 23 haben je fünf Feldfacetten-Gruppen 19 sowie je eine Restgruppe 26 zu fünf Feldfacetten 11. Die mittlere Spalte 22 hat sechs Feldfacetten-Gruppen 19. Die Feldfacetten-Spalten 20 bis 24 sind derart symmetrisch angeordnet, dass sie einen Begrenzungskreis 27, in den die Spalten 20 bis 24 eingeschrieben sind, größtenteils ausfüllen. Auch eine andere Gruppen-Unterteilung des Feldfacetten-Spiegels 10 ist möglich. Insbesondere kann eine andere Anzahl von Feldfacetten-Spalten vorgesehen sein. Weiterhin ist es möglich, weniger oder mehr als zehn Feldfacetten pro Gruppe anzuordnen.

Der Feldfacetten-Spiegel 10 ist unterteilt in eine stationäre Untereinheit 28 und eine Wechsel-Untereinheit 29. Eine Grenze zwischen den Untereinheiten 28, 29 ist in der Fig. 2 gestrichelt dargestellt. Die Wechsel-Untereinheit 29 umfasst die beiden untersten Gruppen 19, 26 der Spalten 21 und 23 sowie die beiden untersten Gruppen 19 der mittleren Spalte 22.

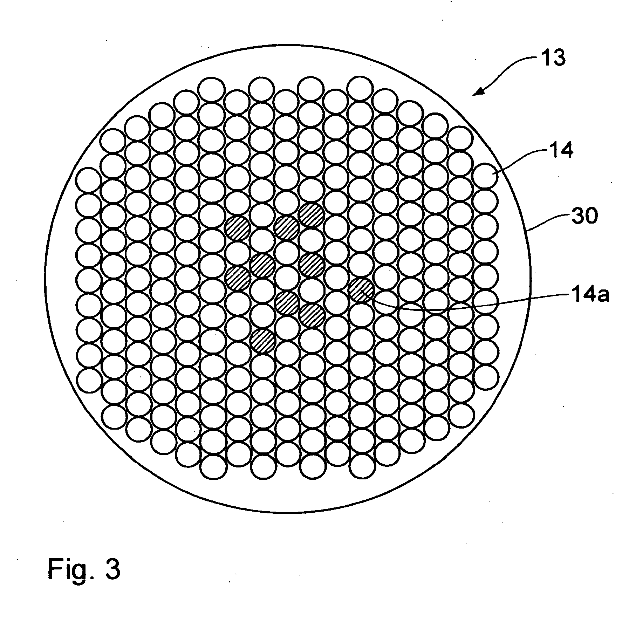

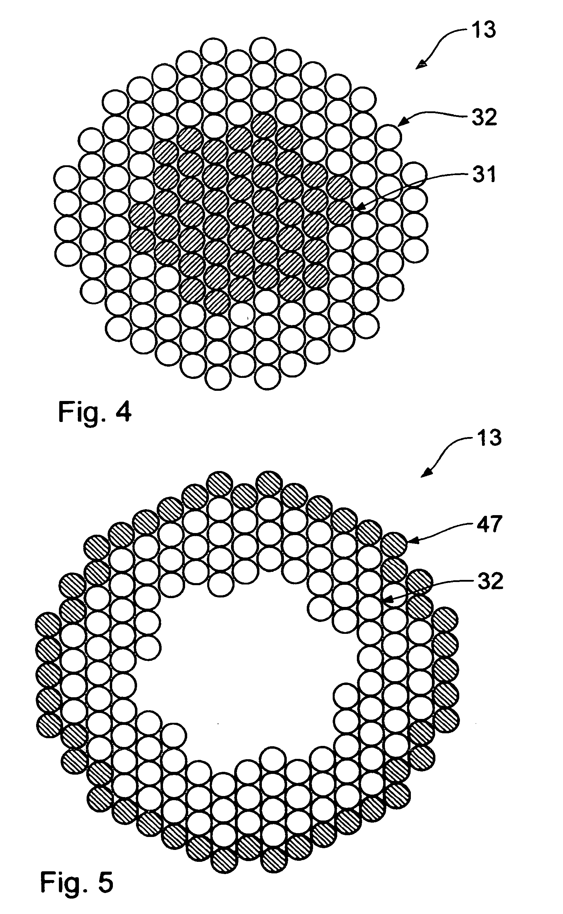

Fig. 3 zeigt schematisch eine Aufsicht auf den Pupillenfacetten-Spiegel 13. Die Pupillenfacetten 14 sind rund und als hexagonal dichteste Packung in einen Begrenzungskreis 30 eingeschrieben. Auch andere dichte Packungen des Pupillenfacetten-Spiegels sind möglich. Die gewählte Packung hängt vom optischen Design und auch von der Form der einzelnen Pupillenfacetten ab. Zusätzlich schematisch angedeutet ist in der Fig. 3 die gruppenweise Ausleuchtung der Pupillenfacetten 14 durch die Feldfacetten 11 einer der Feldfacetten-Gruppen 19 der Wechsel-Untereinheit 29, beispielsweise der in Fig. 2 oberen der beiden Feldfacetten-Gruppen 19 der mittleren Spalte 22 der Wechsel-Untereinheit 29. Die zehn Feldfacetten 11 dieser Gruppe 19 beleuchten zehn in einem zentralen Teilbereich des Pupillenfacetten-Spiegels 13 angeordnete Pupillenfacetten 14a, die in der Fig. 3 schräg schraffiert hervorgehoben sind. Dieser zentrale Teilbereich stellt einen kleinen Bruchteil der gesamten Apertur des Pupillenfacetten-Spiegels 13 dar. Zwischen den so beleuchteten Feldfacetten 14a verbleiben von dieser Gruppe 19 unbeleuchtete Feldfacetten 14, die von anderen Feldfacetten der Wechsel-Untereinheit 29 beleuchtet werden. Insgesamt beleuchten die Feldfacetten 11 der Wechsel-Untereinheit 29 einen zentralen Teilbereich 31 des Pupillenfacetten-Spiegels 13 komplett, wie in der Fig. 4 angedeutet ist. Die Feldfacetten 11 der stationären Untereinheit 28 des Feldfacetten-Spiegels 10 nach Fig. 2 beleuchten einen ersten Ring-Teilbereich 32 um den zentralen Teilbereich 31.

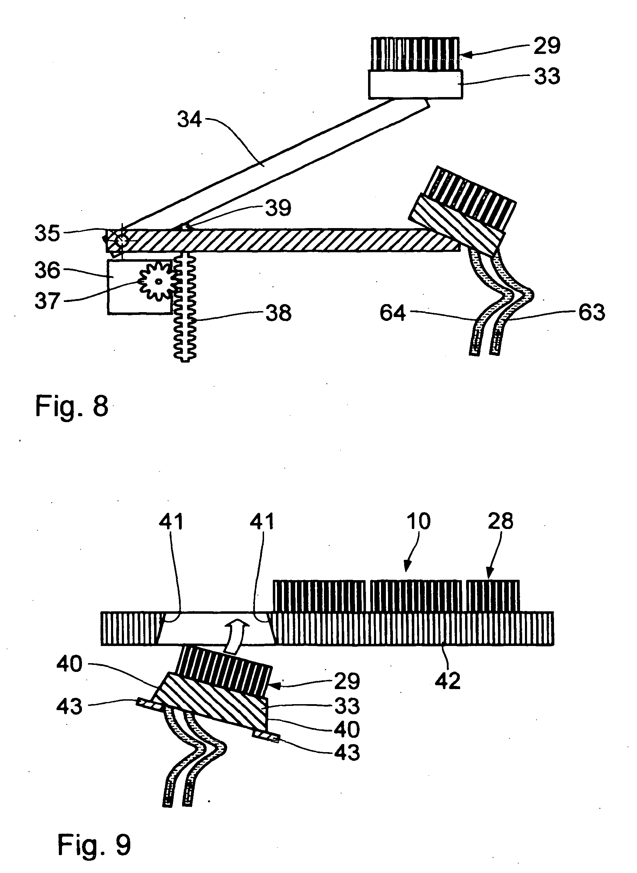

Auch in der Fig. 1 ist die Trennung zwischen der stationären Untereinheit 28 und der Wechsel-Untereinheit 29 des Feldfacetten-Spiegels 10 gestrichelt angedeutet. Die Wechsel-Untereinheit 29 ist dabei in einer Spiegelposition dargestellt, in der sie die stationäre Untereinheit 28 zum gesamten Feldfacetten-Spiegel 10 komplettiert. In der Spiegelposition ist die jeweilige Wechsel-Untereinheit positions- und winkelgenau in Stellung. Ein Grundkörper 33 der Wechsel-Untereinheit 29 ist an einem freien Ende eines Hebelarms 34 angelenkt, wie detaillierter, aber immer noch schematisch in der Fig. 8 dargestellt. Zur Verlagerung der Wechsel-Untereinheit 29 zwischen der Spiegelposition und einer in der Fig. 8 schraffiert dargestellten abgesenkten Neutralposition, also zur Positionierverlagerung der Wechsel-Untereinheit 29, ist der Hebelarm 34 motorisch um ein Drehgelenk 35 verschwenkbar. Als Positionierantrieb 36 dient ein Getriebemotor. Ein von diesem angetriebenes Zahnrad 37 greift in eine Zahnstange 38 ein, deren freies Ende 39 beabstandet zum Drehgelenk 35 an der Unterseite des Hebelarms 34 anliegt.

Wie in der Fig. 9 schematisch dargestellt, weist der Grundkörper 33 der Wechsel-Untereinheit 29 schräge seitliche Führungsflächen 40 auf, die komplementär zu Führungsflächen 41 eines Grundkörpers 42 der stationären Untereinheit 28 des Feldfacetten-Spiegels 10 ausgebildet sind. Die Spiegelposition der Wechsel-Untereinheit 29 wird zudem exakt definiert durch Anschläge 43, die in der Spiegelposition von unten her an der Unterseite des Grundkörpers 42 anliegen. Die Spiegelposition kann zudem durch eine nicht näher dargestellte Rasteinheit fixiert sein.

Der Positionierantrieb 36 ist Teil einer Wechseleinrichtung 44 zum Austausch der Wechsel-Untereinheit 29 des Feldfacetten-Spiegels 10 gegen mindestens eine weitere Wechsel-Untereinheit. Die im Austausch gegen die Wechsel-Untereinheit 29 einsetzbare Untereinheit wird nachfolgend als Wechsel-Untereinheit 29' bezeichnet. Die Wechseleinrichtung 44 wird im Zusammenhang mit weiteren Ausführungen des Feldfacetten-Spiegels noch näher beschrieben werden. Die Wechseleinrichtung 44 steht über eine Signalleitung 45 mit einer zentralen Steuereinrichtung 46 der Projektionsbelichtungsanlage 1 in Signalverbindung.

Die Wechseleinrichtung 44 ist mittels eines Wechselantriebs 44a um eine zentrale Schwenkachse 44b, die in der Fig. 1 vertikal von oben nach unten verläuft, schwenkbar. Hierdurch kann, sobald die Wechsel-Untereinheit 29 in eine Neutralposition abgesenkt wurde, zwischen der Wechsel-Untereinheit 29 und der weiteren Wechsel-Untereinheit 29', die an einem weiteren Hebelarm 34 angebracht ist, getauscht werden. Die Wechsel-Untereinheiten 29, 29' sind, da die Schwenkachse 44b bezogen auf den Feldfacetten-Spiegel 10 exzentrisch angeordnet ist, tangential zum stationären Teil des Feldfacetten-Spiegels gelegen. Die Wechseleinrichtung 44 wird daher auch als tangentiale Wechseleinrichtung bezeichnet.

Die weitere Wechsel-Untereinheit 29', gegen die die Wechsel-Untereinheit 29 des Feldfacetten-Spiegels 10 nach Fig. 2 ausgetauscht werden kann, ist in der Zeichnung nicht eigens dargestellt. Die weitere Wechsel-Untereinheit hat in der Ansicht nach Fig. 2 den gleichen Aufbau und die gleiche Form wie die Wechsel-Untereinheit 29. Der Unterschied zwischen beiden Wechsel-Untereinheiten liegt in der individuellen Kippung der Feldfacetten 11. Diese ist bei der weiteren Wechsel-Untereinheit so, dass durch diese nicht ein zentraler Teilbereich des Pupillenfacetten-Spiegels 13 ausgeleuchtet wird, sondern ein den ersten Ring-Teilbereich 32 umgebender äußerer Ring-Teilbereich 47. Die Beleuchtungssituation des Pupillenfacetten-Spiegels 13 mit der zum Austausch gegen die Wechsel-Untereinheit 29 eingesetzten weiteren Wechsel-Untereinheit 29' ist in der Fig. 5 dargestellt. Der zentrale Teilbereich 31 wird dann nicht mehr ausgeleuchtet. Ausgeleuchtet werden nun die beiden Ring-Teilbereiche 32 und 47. Durch Austausch der Wechsel-Untereinheit 29 gegen die weitere Wechsel-Untereinheit 29' kann also von einem konventionellen Beleuchtungssetting zu einem annularen Beleuchtungssetting gewechselt werden.

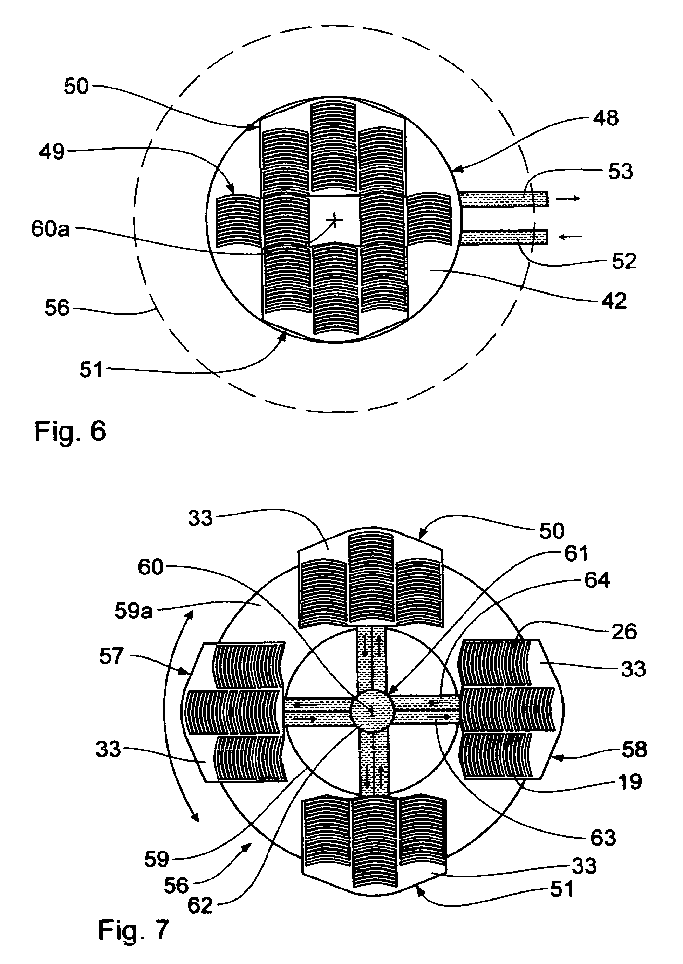

Fig. 6 zeigt ein weiteres Beispiel eines Feldfacetten-Spiegels 48. Komponenten, die denjenigen entsprechen, die vorstehend schon unter Bezugnahme auf die Figuren 1 bis 5 sowie 8 und 9 beschrieben wurden, tragen die gleichen Bezugsziffern und werden nicht nochmals im Einzelnen erläutert.

Neben einer stationären Untereinheit 49 hat der Feldfacetten-Spiegel 48 zwei Wechsel-Untereinheiten 50, 51. Beide Wechsel-Untereinheiten 50, 51 sind in der Fig. 6 in der Spiegelposition dargestellt. Die Untereinheiten 49 bis 51 werden über eine Kühlflüssigkeit gekühlt. Letztere tritt in den Grundkörper 42 des Feldfacetten-Spiegels 48 über eine Eintrittsleitung 52 ein und über eine Austrittsleitung 53 aus.

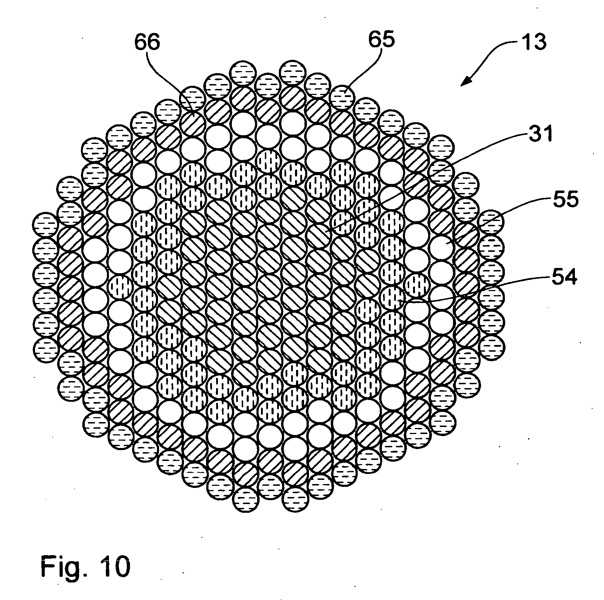

Die in der Fig. 6 oben dargestellte Wechsel-Untereinheit 50 beleuchtet den zentralen Teilbereich 31 des Pupillenfacetten-Spiegels 13, wie in der Fig. 10 dargestellt. Die in der Fig. 6 unten dargestellte Wechsel-Untereinheit 51 beleuchtet einen ersten Ring-Teilbereich 54 um den zentralen Teilbereich 31. Die stationäre Untereinheit 49 beleuchtet einen den ersten Ring-Teilbereich 54 ungebenden weiteren Ring-Teilbereich 55. Die Teilbereiche 31, 54 und 55 haben dabei zusammen 155 Pupillenfacetten 14. Der zentrale Teilbereich 31 und der Ringbereich 66 haben jeweils 49 Pupillenfacetten 14. Der Ringbereich 54 und der äußere Ringbereich 65 haben jeweils 54 Pupillenfacetten 14. Insgesamt weist der Pupillenfacetten-Spiegel 13 also 257 Pupillenfacetten 14 auf.

Auf der der EUV-Strahlung 8 abgewandten Seite, also in der Fig. 6 unterhalb der Zeichenebene unter dem Grundkörper 42 ist eine in der Fig. 7 schematisch dargestellte Wechseleinrichtung 56 zum Austausch der Wechsel-Untereinheiten 50, 51 gegen weitere Wechsel-Untereinheiten 57, 58 angeordnet. Die Wechsel-Untereinheiten 50, 51, 57, 58 sind in der Fig. 7 in der abgesenkten Neutralposition dargestellt. Details des Positionierantriebs, der bei der Wechseleinrichtung 56 genauso aufgebaut ist wie in den Fig. 8 und 9 dargestellt, sind in der Fig. 7 weggelassen.

Über einen in der Fig. 7 schematisch angedeuteten Wechselantrieb 59 kann die Wechseleinrichtung 56 um eine zentrale und zur Zeichenebene der Fig. 7 senkrechte Schwenkachse 60 insbesondere stufenlos um 90° verschwenkt werden. Die Wechsel-Untereinheiten 50, 51, 57, 58 sind auf einem ringförmigen Untereinheiten-Träger 59a angeordnet, der den Wechselantrieb 59 umgibt. Die Schwenkachse 60 fällt mit einer Zentralachse 60a des Feldfacetten-Spiegels 48 zusammen. Die Wechseleinrichtung 56 wird daher genauso wie die nachfolgend noch beschriebenen Wechseleinrichtungen auch als kreisförmige Wechseleinrichtung bezeichnet.

Die Wechseleinrichtung 56 hat ein Förderleitungssystem 61 zur Kühlung der Untereinheiten 50, 51, 57, 58 mit Kühlflüssigkeit. Ein Leitungsabschnitt 62 des Förderleitungssystems 60 verläuft längs der Schwenkachse 60. Mit dem Leitungsabschnitt 62 verbunden sind jeweils Eintrittsleitungen 63 und Austrittsleitungen 64 für die Kühlflüssigkeits-Führung hin zu und weg von den Grundkörpern 33 der Wechsel-Untereinheiten 50,51,57,58. Die Leitungen 63, 64 sind, wie in den Fig. 8 und 9 angedeutet, flexibel, sodass sie die Verlagerung der Wechsel-Untereinheiten 29 bzw. 50, 51, 57, 58 nicht behindern.

Zum Austausch der Wechsel-Untereinheiten 50, 51 durch die Wechsel-Untereinheiten 57, 58 werden die Wechsel-Untereinheiten 50, 51 zunächst von der Spiegelposition durch Betätigung ihrer Positionsantriebe 36 in die Neutralpositionen abgesenkt. Anschließend wird der Wechselantrieb 59 aus der in der Fig. 7 gezeigten Position um 90° im Uhrzeigersinn um die Schwenkachse 60 verschwenkt.

Anschließend werden die Wechsel-Untereinheiten 57, 58 aus der Neutralposition über Betätigung von deren Positionsantrieben 36 in die Spiegelposition angehoben, bis die Führungsflächen 40, 41 aneinander anliegen und die Anschläge 43 an der Unterseite des Grundkörpers 42 der stationären Untereinheit 49 anliegen. Zur Fixierung der Spiegelposition kann auch noch ein Verrasten der Wechsel-Untereinheiten 57, 58 durch die nicht dargestellte Rasteinheit erfolgen.

Die Wechsel-Untereinheit 58 beleuchtet einen äußeren Ring-Teilbereich 65 des Pupillenfacetten-Spiegels 13. Die Wechsel-Untereinheit 57 beleuchtet einen Nachbar-Ring-Teilbereich 66 des Pupillenfacetten-Spiegels 13, der dem äußeren Ring-Teilbereich 65 innen benachbart ist. Bei eingesetzten Wechsel-Untereinheiten 57, 58 bleiben die Teilbereiche 31 sowie 54 des Pupillenfacetten-Spiegels 13 unbeleuchtet.

Durch den Austausch der Wechsel-Untereinheiten 50, 51 durch die Wechsel-Untereinheiten 57, 58 wird also zwischen einem konventionellen Beleuchtungssetting und einem annularen Beleuchtungssetting gewechselt.

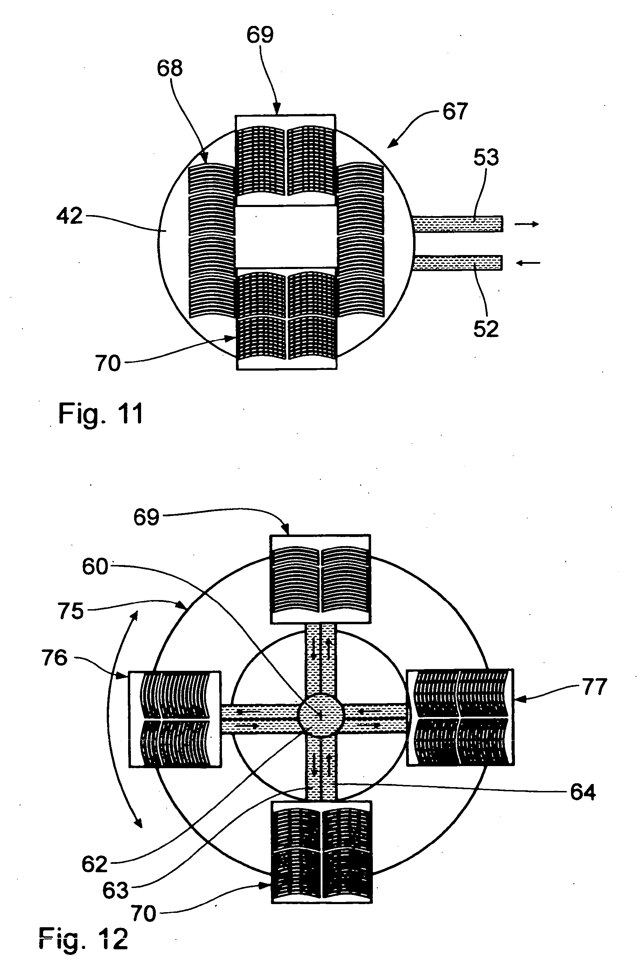

Fig. 11 zeigt eine weitere Variante eines Feldfacetten-Spiegels 67. Komponenten, die denjenigen entsprechen, die vorstehend schon unter Bezugnahme auf die Fig. 1 bis 10 beschrieben wurden, tragen die gleichen Bezugsziffern und werden nicht nochmals im Einzelnen erläutert.

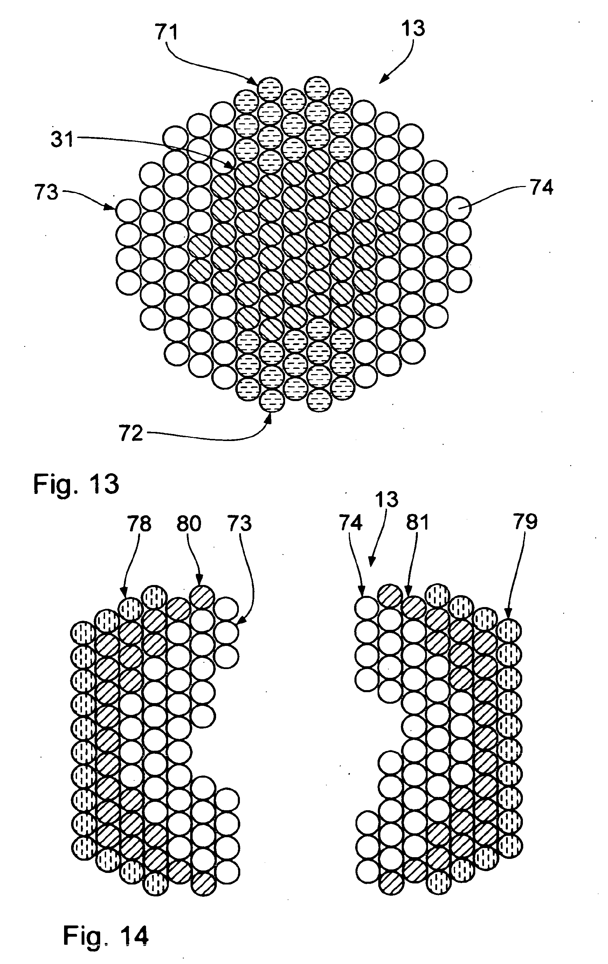

Der Feldfacetten-Spiegel 67 hat eine stationäre Untereinheit 68 und zwei Wechsel-Untereinheiten 69, 70. Im Unterschied zu den teilsegmentförmigen Randbegrenzungen der Wechsel-Untereinheiten 29 bzw. 50, 51, 57, 58 sind die Begrenzungen der Wechsel-Untereinheiten 69, 70 rechteckig. Die in der Fig. 11 unten dargestellte Wechsel-Untereinheit 70 beleuchtet den zentralen Teilbereich 31 des Pupillenfacetten-Spiegels 13. Die in der Fig. 11 oben dargestellte Wechsel-Untereinheit 69 beleuchtet zwei einander gegenüberliegende Teilbereiche 71, 72, die dem zentralen Teilbereich 31 benachbart sind. Der Teilbereich 71 ist dabei in der Fig. 13 oberhalb des zentralen Teilbereichs 31 angeordnet und der Teilbereich 72 ist in der Fig. 13 unterhalb des zentralen Teilbereichs 31 angeordnet.

Die stationäre Untereinheit 68 beleuchtet Rest-Teilbereiche 73, 74, sodass alle Teilbereiche 31, 71, 72, 73, 74 zusammen eine konventionelle Beleuchtung ergeben. Die konventionelle Beleuchtung, auch konventionelles Setting genannt, entspricht einer kreisförmigen Ausleuchtung mit innerhalb des Kreises möglichst gleichmäßiger Intensität. Die Rest-Teilbereiche 73, 74 stellen teilkreisförmige Nachbar-Rand-Teilbereiche zum zentralen Teilbereich 31 dar.

Eine Wechseleinrichtung 75 für den Feldfacetten-Spiegel, die ansonsten genauso aufgebaut ist wie die Wechseleinrichtung 56, hat neben den Wechsel-Untereinheiten 69, 70 noch weitere Wechsel-Untereinheiten 76, 77. Die Wechsel-Untereinheit 76 ist in der Fig. 12 links und die Wechsel-Untereinheit 77 in der Fig. 12 recht dargestellt. Entsprechend zu dem, was vorstehend in Bezug auf die Wechseleinrichtung 56 erläutert wurde, kann mit der Wechseleinrichtung 75 zwischen den Wechsel-Untereinheiten 69, 70 und den Wechsel-Untereinheiten 76, 77 getauscht werden. Dabei wird die Wechseleinrichtung 75 aus der in der Fig. 12 gezeigten Stellung um 90° im Uhrzeigersinn um die zentrale Schwenkachse 62 verschwenkt. Bei ausgetauschten Wechsel-Untereinheiten kommt daher die Wechsel-Untereinheit 76 an die Stelle der Wechsel-Untereinheit 69 und die Wechsel-Untereinheit 77 an die Stelle der Wechsel-Untereinheit 70. Die Wechsel-Untereinheit 76 beleuchtet zwei einander in der Fig. 14 links und rechts gegenüberliegende teilkreisförmige äußere Rand-Teilbereiche 78, 79 des Pupillenfacetten-Spiegels 13. Die Wechsel-Untereinheit 77 beleuchtet zwei in der Fig. 14 einander links und rechts gegenüberliegende teilkreisförmige Nachbar-Rand-Teilbereiche 80, 81 des Pupillenfacetten-Spiegels 13, die den äußeren Rand-Teilbereichen 78, 79 benachbart sind. Bei eingesetzten Wechsel-Untereinheiten 76, 77 bleiben die Teilbereiche 31 sowie 71, 72 des Pupillenfacetten-Spiegels 13 unbeleuchtet.

Bei in den Pupillenfacetten-Spiegel 67 eingesetzten Wechsel-Untereinheiten 76, 77 resultiert daher eine Dipol-Beleuchtung mit zwei symmetrisch ausgeleuchteten Bereichen (Dipol-Setting).

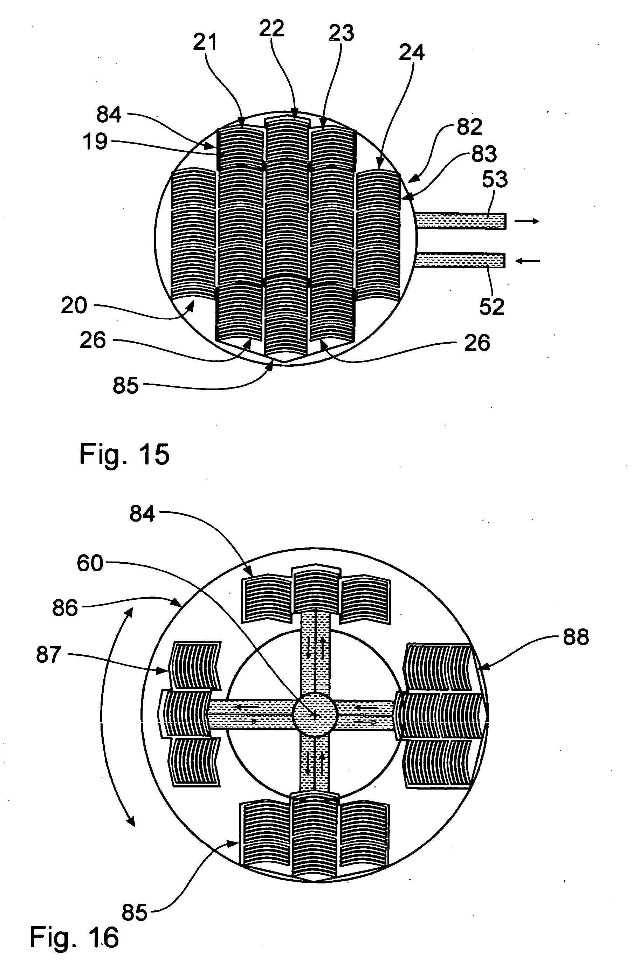

Fig. 15 zeigt eine weitere Ausführung eines Feldfacetten-Spiegels 82. Komponenten, die denjenigen entsprechen, die vorstehend schon unter Bezugnahme auf die Fig. 1 bis 14 erläutert wurden, tragen die gleichen Bezugsziffern und werden nicht nochmals im Einzelnen diskutiert.

Die Anordnung der Feldfacetten 11 entspricht beim Feldfacetten-Spiegel 82 der Anordnung beim Feldfacetten-Spiegel 10. Der Feldfacetten-Spiegel 82 hat eine stationäre Untereinheit 83 und zwei Wechsel-Untereinheiten 84, 85. Die Wechsel-Untereinheit 84 ist in der Fig. 15 oben und die Wechsel-Untereinheit 85 in der Fig. 15 unten dargestellt. Die Wechsel-Untereinheiten 84, 85 sind unterschiedlich groß, weisen also eine unterschiedliche Anzahl von Feldfacetten 11 auf. Die in der Fig. 15 obere Wechsel-Untereinheit 84 hat drei Feldfacetten-Gruppen 19, die die oberen Gruppen in den Feldfacetten-Spalten 21, 22, 23 bilden.

Die in der Fig. 15 untere Wechsel-Untereinheit 85 bildet den unteren Abschluss der Feldfacetten-Spalten 21 bis 23. In der Feldfacetten-Spalte 21 weist die Wechsel-Untereinheit 85 eine Feldfacetten-Gruppe 19 und die Restgruppe 26 auf. In der Feldfacetten-Spalte 22 umfasst die Wechsel-Untereinheit 85 zwei Feldfacetten-Gruppen 19. In der Feldfacetten-Spalte 23 weist die Wechsel-Untereinheit 85 eine Feldfacetten-Gruppe 19 und die Restgruppe 26 auf.

Mit den Wechsel-Untereinheiten 84, 85 werden entsprechend ihrer unterschiedlichen Größe und damit unterschiedlichen Anzahl von Feldfacetten 11 auch in ihren Flächen unterschiedliche Teilbereiche des Pupillenfacetten-Spiegels 13 ausgeleuchtet. Dies kann in Situationen genutzt werden, bei denen beispielsweise der zentrale Teilbereich 31 (vgl. Fig. 10) eine größere Anzahl von Pupillenfacetten 14 aufweist als der sich hieran anschließende Ring-Teilbereich 54.

Eine Wechseleinrichtung 86 für den Feldfacetten-Spiegel 82 hat neben den Wechsel-Untereinheiten 84, 85 noch weitere Wechsel-Untereinheiten 87, 88. Abgesehen von der Ausgestaltung der Wechsel-Untereinheiten 84, 85, 87, 88 entspricht die Ausführung der Wechseleinrichtung 86 derjenigen der Wechseleinrichtung 56.

In ihrer äußeren Kontur entspricht die Wechsel-Untereinheit 87 der Wechsel-Untereinheit 84. Genauso entspricht die Wechsel-Untereinheit 88 der Wechsel-Untereinheit 85 in ihrer äußeren Kontur. Wie im Zusammenhang mit der Wechseleinrichtung 56 bereits erläutert, kann also auch mit der Wechseleinrichtung 86 zwischen den Wechsel-Untereinheiten 84, 85 und den Wechsel-Untereinheiten 87, 88 durch Verschwenken der Wechseleinrichtung 86 um die Schwenkachse 60 um 90° im Uhrzeigersinn getauscht werden. Die Wechsel-Untereinheiten 87, 88 beleuchten andere Teilbereiche auf dem Pupillenfacetten-Spiegel 13 als die Wechsel-Untereinheiten 84, 85. Auf diese Weise kann auch mit der Wechseleinrichtung 86 zwischen unterschiedlichen Beleuchtungssettings gewechselt werden.

Eine nicht dargestellte Ausführungsform einer Wechseleinrichtung kann auch eine höhere Anzahl von Wechsel-Untereinheiten aufweisen, sodass bei einem zugehörigen Feldfacetten-Spiegel zwischen mehr als zwei Wechsel-Untereinheiten-Konfigurationen getauscht werden kann. Mit einer derartigen, nicht dargestellten Wechseleinrichtung kann beispielsweise zwischen einem konventionellen Setting, einem annularen Setting und einem Dipol-Setting gewechselt werden. Je nach der Ausgestaltung der Wechsel-Untereinheiten können durch deren Austausch auch andere Beleuchtungssettings vorgegeben werden, z. B. ein Quadrupol-Beleuchtungssetting, ein konventionelles Beleuchtungssetting mit unterschiedlichem maximalen Beleuchtungswinkel (unterschiedliches Sigma) oder auch weitere, exotische Beleuchtungssettings. Dipol-, Quadrupol- und annulare Beleuchtungssettings erlauben es, mit einer Projektionsbelichtungsanlage, insbesondere unter Einsatz von EUV-Beleuchtungsstrahlung, feinere Strukturen abzubilden, als dies in der Regel mit konventionellen Settings möglich ist. Die von den Wechsel-Untereinheiten oder der stationären Untereinheit jeweils beleuchteten Teilbereiche haben die zum Zusammensetzen des jeweiligen Beleuchtungssettings erforderliche Form. Neben den vorstehend bereits beschriebenen Formen der Teilbereiche können auch z. B. sektorförmige oder in anderer Weise randseitig konturierte Teilbereiche ausgeleuchtet werden.

Pro Feldfacetten-Spiegel können auch mehr als zwei Wechsel-Untereinheiten vorgesehen sein.

Alternativ zu einer tangentialen Wechseleinrichtung 44, wie in der Fig. 1 angedeutet oder einer kreisförmigen Wechseleinrichtung 56, 75, 86 kann auch eine lineare Wechseleinrichtung vorgesehen sein, bei der die einzelnen Wechsel-Untereinheiten auf einem längs, z. B. senkrecht zur Zeichenebene der Fig. 1, verschiebbaren Schlitten angeordnet sind.

Die dargestellten Wechsel-Untereinheiten weisen jeweils mehrere Feldfacetten 11 auf, die zu Feldfacetten-Gruppen zusammengefasst sind.

Zur Herstellung eines mikro- bzw. nanostrukturierten Bauteils wird das Retikel 2 mit der abzubildenden Struktur, also dem abzubildenden Muster, im Objektfeld in der Retikel- bzw. Objektebene 3 positioniert. Im Bildfeld in der Bild- bzw. Waferebene 5 wird der Wafer 4 positioniert. Beim Betrieb der Projektionsbelichtungsanlage 1 wird nun das Muster auf dem Retikel 2 auf eine beleuchtungslichtempfindliche Schicht des Wafers 4 projiziert. Diese Schicht kann dann zur Herstellung des mikro- bzw. nanostrukturierten Bauteils entwickelt werden.

Bei einem ersten Projektionsschritt oder einer ersten Sequenz von Projektionsschritten ist der die Wechsel-Untereinheiten aufweisende Facetten-Spiegel, in den dargestellten Ausführungsbeispielen also der Feldfacetten-Spiegel, in einer ersten Zusammenstellung seiner Untereinheiten eingesetzt. Sobald ein weiteres Beleuchtungssetting erforderlich ist, wird eine Untereinheit des Facetten-Spiegels gegen eine Wechsel-Untereinheit zur Erzeugung einer zweiten Zusammenstellung von Untereinheiten des Facetten-Spiegels ausgetauscht. Es folgt nun eine weitere Projektion mit dem Facetten-Spiegel in der zweiten Zusammenstellung der Untereinheiten.

Beim Wechsel zwischen zwei Beleuchtungssettings kann genau eine der Untereinheiten des Facetten-Spiegels ausgetauscht werden. Auch ein Austausch von mindestens zwei Untereinheiten ist zum Wechsel des Beleuchtungssettings möglich.

## Patentansprüche

1. Beleuchtungsoptik (6) für die EUV-Projektions-Mikrolithographie zur Beleuchtung eines Beleuchtungsfeldes in einer Retikelebene (3) mit EUV-Strahlung (8),
- mit mindestens einem Facetten-Spiegel (10; 48; 67; 82) mit einer Mehrzahl von Facetten (11) zur Erzeugung eines definierten Beleuchtungssettings zur Beleuchtung und Ausleuchtung des Beleuchtungsfeldes, wobei die Facetten (11) jeweils Teilbündeln der EUV-Strahlung (8) zugeordnet sind, wobei
- der Facetten-Spiegel (10; 48; 67; 82) in Untereinheiten (28, 29; 49, 50, 51; 49, 57, 58; 68, 69, 70; 68, 76, 77; 83, 84, 85; 83, 87, 88) unterteilt ist, die ihrerseits aus Facetten-Gruppen (19, 25, 26) aufgebaut sind,
wobei
die Beleuchtungsoptik (6) eine Wechseleinrichtung (44; 56; 75; 86) zum Austausch mindestens einer der Untereinheiten (29; 50, 51; 69, 70; 84, 85) des Facetten-Spiegels (10; 48; 67; 82) gegen mindestens eine Wechsel-Untereinheit (57, 58; 69, 70; 84, 85) aufweist.

2. Beleuchtungsoptik nach Anspruch 1, **dadurch gekennzeichnet, dass**
- es sich bei dem mindestens einen Facetten-Spiegel (10; 48; 67; 82) um einen Feldfacetten-Spiegel mit einer Mehrzahl von Feldfacetten (11) zur Erzeugung von sekundären Lichtquellen handelt,
- wobei ein Pupillenfacetten-Spiegel (13) im Bereich mindestens einiger der vom Feldfacetten-Spiegel (10; 48; 67; 82) erzeugten sekundären Lichtquellen mit einer Mehrzahl von Pupillenfacetten (14) vorhanden ist, die über die ihnen zugeordneten Feldfacetten (11) mit EUV-Strahlung (8) beaufschlagt werden,
- wobei der Pupillenfacetten-Spiegel (13) Teil einer optischen Einrichtung (15) ist, welche den Feldfacetten-Spiegel (10; 48; 67; 82) in die Retikelebene (3) abbildet.

3. Beleuchtungsoptik nach Anspruch 2, **dadurch gekennzeichnet, dass** die Feldfacetten (11) des Feldfacetten-Spiegels (10; 48; 67; 82) so ausgerichtet sind, dass eine Untereinheit (19, 25, 26) des Feldfacetten-Spiegels (10; 48; 67; 82) Pupillenfacetten (14) beleuchtet, die innerhalb eines verglichen mit der gesamten Apertur des Pupillenfacetten-Spiegels (13) kleinen Teilbereichs (31, 32, 47; 31, 54, 55, 65, 66; 31, 71, 72, 73, 74, 78, 79, 80, 81) des Pupillenfacetten-Spiegels (13) angeordnet sind.

4. Beleuchtungsoptik nach einem der Ansprüche 1 bis 3, **dadurch gekennzeichnet, dass** die Wechseleinrichtung (44; 56; 75; 86) aufweist,
- einen Wechselantrieb (44a; 59) zur Wechsel-Verlagerung eines Untereinheiten-Trägers (59a) derart, dass im Feldfacetten-Spiegel (10; 48; 67; 82) zwischen zwei Untereinheiten (50, 51, 57, 58; 69, 70, 76, 77; 84, 85, 87, 88) gewechselt wird,
- einen Positionierantrieb (36) zur Positionier-Verlagerung eines Grundkörpers (33) einer der Untereinheiten (29; 50, 51, 57, 58; 69, 70, 76, 77; 84, 85, 87, 88) der Wechseleinrichtung (44; 56; 75; 86) zwischen einer Spiegelposition, in der die Untereinheit (29; 50, 51, 57, 58; 69, 70, 76, 77; 84, 85, 87, 88) im Feldfacetten-Spiegel (10; 48; 67; 82) in Position vorliegt und einer Neutralposition, in der eine Wechsel-Verlagerung des Untereinheiten-Trägers (59a) möglich ist.

5. Beleuchtungsoptik nach Anspruch 4, **dadurch gekennzeichnet, dass** der Wechselantrieb (44a; 59) einen Schwenkantrieb des Untereinheiten-Trägers (59a) zur Wechsel-Verlagerung um eine Schwenkachse (44b) aufweist.

6. Beleuchtungsoptik nach Anspruch 5, **dadurch gekennzeichnet, dass** die Schwenkachse (60) mit einer Zentralachse (60a) des Feldfacetten-Spiegels (48; 67; 82) zusammenfällt.

7. Beleuchtungsoptik nach einem der Anspruch 1 bis 6, **dadurch gekennzeichnet, dass** die Wechseleinrichtung (44; 56; 75; 86) ein Förderleitungssystem (61) für ein die austauschbaren Untereinheiten (29; 50, 51, 57, 58; 69, 70, 76, 77; 84, 85, 87, 88) kühlendes Kühlmedium aufweist, wobei ein Leitungsabschnitt (62) des Förderleitungssystems (61) längs der Schwenkachse (60) verläuft.

8. Beleuchtungsoptik nach Anspruch 7, **dadurch gekennzeichnet, dass** mindestens ein Leitungsabschnitt (63, 64) des Förderleitungssystems (61) flexibel ausgeführt ist.

9. Beleuchtungsoptik nach einem der Ansprüche 4 bis 8, **dadurch gekennzeichnet, dass** der Positionierantrieb (36) einen Hebelarm (34) aufweist, der an seinem freien Ende am Grundkörper (33) angelenkt ist und zur Positionsverlagerung motorisch um ein Drehgelenk (35) verschwenkbar ist.

10. Beleuchtungsoptik nach einem der Ansprüche 4 bis 9, **gekennzeichnet durch** mindestens einen Anschlag (43) zur definierten Vorgabe der Spiegelposition.

11. Beleuchtungsoptik nach einem der Ansprüche 4 bis 10, **gekennzeichnet durch** mindestens eine Rasteinheit zur Fixierung der Spiegelposition.

12. Beleuchtungsoptik nach einem der Ansprüche 2 bis 11, **dadurch gekennzeichnet, dass** mindestens ein Teilbereich (32; 55; 73, 74) des Pupillenfacetten-Spiegels (13) und / oder des Beleuchtungsfeldes von stationären, also nicht auswechselbaren, Untereinheiten (28; 49; 68; 83) des Facetten-Spiegels (10; 48; 67; 82) beleuchtet wird.

13. Beleuchtungsoptik nach einem der Ansprüche 2 bis 12, **dadurch gekennzeichnet, dass** eine auswechselbare Untereinheit (29; 50; 70) einen zentralen Teilbereich (31) des Pupillenfacetten-Spiegels (13) beleuchtet.

14. Beleuchtungsoptik nach einem der Ansprüche 2 bis 13, **dadurch gekennzeichnet, dass** eine auswechselbare Untereinheit (51) einen ersten Ring-Teilbereich (54) um einen zentralen Teilbereich (31) des Pupillenfacetten-Spiegels (13) beleuchtet.

15. Beleuchtungsoptik nach einem der Ansprüche 2 bis 14, **dadurch gekennzeichnet, dass** eine auswechselbare Untereinheit (29'; 58) einen äußeren Ring-Teilbereich (47; 65) des Pupillenfacetten-Spiegels (13) beleuchtet.

16. Beleuchtungsoptik nach einem der Ansprüche 2 bis 15, **dadurch gekennzeichnet, dass** eine auswechselbare Untereinheit (57) einen Nachbar-Ring-Teilbereich (66) des Pupillenfacetten-Spiegels (13) beleuchtet, der einem äußeren Ring-Teilbereich (65) benachbart ist.

17. Beleuchtungsoptik nach einem der Ansprüche 2 bis 16, **dadurch gekennzeichnet, dass** eine auswechselbare Untereinheit (76) zwei einander gegenüberliegende teilkreisförmige oder sektorförmige äußere Rand-Teilbereiche (78, 79) des Pupillenfacetten-Spiegels (13) beleuchtet.

18. Beleuchtungsoptik nach einem der Ansprüche 2 bis 17, **dadurch gekennzeichnet, dass** eine auswechselbare Untereinheit (77) zwei einander gegenüberliegende teilkreisförmige oder sektorförmige Nachbar-Rand-Teilbereiche (80, 81) des Pupillenfacetten-Spiegels (13) beleuchtet, die äußeren Rand-Teilbereichen (78, 79) des Pupillenfacetten-Spiegels (13) benachbart sind.

19. Beleuchtungsoptik nach einem der Ansprüche 2 bis 18, **dadurch gekennzeichnet, dass** eine auswechselbare Untereinheit (69) einander gegenüberliegende Teilbereiche (71, 72) beleuchtet, die dem zentralen Teilbereich (31) benachbart sind.

20. Beleuchtungssystem mit
- einer Beleuchtungsoptik nach einem der Ansprüche 1 bis 19,
- einer EUV-Lichtquelle (7).

21. Projektionsbelichtungsanlage (1) mit
- einem Beleuchtungssystem nach Anspruch 20,
- einer Projektionsoptik (18) zur Abbildung des Beleuchtungsfeldes in ein Bildfeld in einer Bildebene (5).

22. Verfahren zur Herstellung eines mikrostrukturierten Bauteils mit folgenden Verfahrensschritten:
- Bereitstellen einer Projektionsbelichtungsanlage nach Anspruch 21,
- Bereitstellen eines Substrats (4), auf das zumindest teilweise eine Schicht aus einem lichtempfindlichen Material aufgebracht ist,
- Bereitstellen einer Maske bzw. eines Retikels (2), aufweisend abzubildende Strukturen,
- Projizieren mindestens eines Teils des Retikels (2) auf einen Bereich der lichtempfindlichen Schicht mit der Projektionsbelichtungsanlage (1).

23. Verfahren nach Anspruch 22 mit folgenden Schritten:
- Einsetzen des Facetten-Spiegels der Beleuchtungsoptik der Projektionsbelichtungsanlage in einer ersten Konfiguration von Untereinheiten während eines ersten Projektionsschrittes,
- Austauschen einer der Untereinheiten des Facetten-Spiegels gegen eine Wechsel-Untereinheit zur Erzeugung einer zweiten Konfiguration von Untereinheiten des Facetten-Spiegels,
- Projizieren mindestens eines Teils des Retikels auf einen Bereich der lichtempfindlichen Schicht mit der Projektionsbelichtungsanlage.

24. Verfahren nach Anspruch 23, bei dem mindestens zwei Untereinheiten des Facetten-Spiegels gegen Wechsel-Untereinheiten zur Erzeugung der zweiten Konfiguration ausgetauscht werden.

## Claims

1. Illumination optics (6) for EUV projection microlithography for an illumination of an illumination field in a reticle plane (3) by means of an EUV radiation (8),
- having at least one facet mirror (10; 48; 67; 82) provided with a plurality of facets (11) to generate a defined illumination setting for illumination of the illumination field, each facet (11) being allocated to a partial beam of the EUV radiation (8), wherein
- the facet mirror (10; 48; 67; 82) is divided into subunits (28, 29; 49, 50, 51; 49, 57, 58; 68, 69, 70; 68, 76, 77; 83, 84, 85; 83, 87, 88) which themselves are composed of facet groups (19, 25, 26), wherein
- the illumination optics (6) has a changing device (44, 56; 75; 86) for interchanging at least one of the subunits (29; 50, 51; 69, 70; 84, 85) of the facet mirror (10, 48; 67; 82) with at least one interchangeable subunit (57, 58; 69, 70; 84, 85).

2. Illumination optics according to claim 1, **characterized in that**
- the at least one facet mirror (10, 48, 67, 82) is configured as a field facet mirror having a plurality of field facets (11) to generate secondary light sources,
-- with a pupil facet mirror (13) being provided in the vicinity of at least some of the secondary light sources generated by the field facet mirror (10, 48, 67, 82), said pupil facet mirror having a plurality of pupil facets (14) which are impinged by EUV radiation (8) via their corresponding field facets (11).
-- with the pupil facet mirror (13) being a part of an optical equipment (15) required to image the field facet mirror (10, 48, 67, 82) in the reticle plane (3).

3. Illumination optics according to claim 2, **characterized in that** the field facets (11) of the field facet mirror (10, 48, 67, 82) are oriented in a way as to enable a subunit (19, 15, 16) of the field facet mirror (10, 48, 67, 82) to illuminate pupil facets (14) which are arranged in a relatively small area (31, 32, 47; 31, 54, 55, 65, 66; 31, 71, 72, 73, 74, 78, 79, 80, 81) of the pupil facet mirror when compared with the entire aperture of the pupil facet mirror (13).

4. Illumination optics according to any one of claims 1 to 3, **characterized in that** the changing device (44; 56; 75; 86) is provided with
- an interchanging drive (44a; 59) for interchanging displacement of a subunit carrier (59a) in a way as to change between two subunits (50, 51, 57, 58; 69, 70, 76, 77; 84, 85, 87, 88) of the field facet mirror (10; 48; 67; 82),
- a positioning drive (36) for positioning displacement of a base body (33) of one of the subunits (29; 50, 51, 57, 58, 69, 70, 76, 77; 88, 85, 87, 88) of the changing device (44; 56; 75; 86) between a mirror position, where the subunit (29; 50, 51, 57, 58, 69, 70, 76, 77; 88, 85, 87, 88) is situated in a fixed position in the field facet mirror (10; 48; 67; 82), and a neutral position for interchanging displacement of the subunit carrier (59a).

5. Illumination optics according to claim 4, **characterized in that** the interchanging drive (44a; 59) is provided with a swivel drive enabling the subunit carrier (59a) to be rotated about a swivel axis (44b).

6. Illumination optics according to claim 5, **characterized in that** the swivel axis (60) coincides with a central axis (60a) of the field facet mirror (48; 67; 82).

7. Illumination optics according to any one of claims 1 to 6, **characterized in that** the changing device (44; 56; 75; 86) is provided with a delivery line system (61) for a cooling medium for cooling the interchangeable subunits (29; 50, 51, 57, 58, 69, 70, 76, 77; 88, 85, 87, 88), with a line section (62) of the delivery line system (61) extending along the swivel axis (60).

8. Illumination optics according to claim 7, **characterized in that** at least one line section (63, 64) of the delivery line system (61) is configured as a flexible line section.

9. Illumination optics according to any one of claims 4 to 8, **characterized in that** the positioning drive (36) is provided with a lever arm (34) a free end of which is attached to a base body (33) and is rotatable about a swivel joint (35) by means of a motor, thus providing for a change of its position.

10. Illumination optics according to any one of claims 4 to 9, **characterized by** at least one stop (43) for defining the mirror position.

11. Illumination optics according to one of the claims 4 to 10, **characterized by** at least one snap-in locking unit for fixing the mirror position.

12. Illumination optics according to any one of claims 2 to 11, **characterized in that** at least one area (32; 55; 73, 74) of the pupil facet mirror (13) and/or the illumination field is illuminated by stationary, i.e. non-interchangeable, subunits (28; 49; 68; 83) of the facet mirror.

13. Illumination optics according to any one of claims 2 to 12, **characterized in that** an interchangeable subunit (29; 50; 70) illuminates a central area (31) of the pupil facet mirror (13).

14. Illumination optics according to any one of claims 2 to 13, **characterized in that** an interchangeable subunit (51) illuminates a first annular area (54) surrounding a central area (31) of the pupil facet mirror (13).

15. Illumination optics according to any one of claims 2 to 14, **characterized in that** an interchangeable subunit (29'; 58) illuminates an external annular area (47; 65) of the pupil facet mirror (13).

16. Illumination optics according to any one of claims 2 to 15, **characterized in that** an interchangeable subunit (57) illuminates an adjacent annular area (66) of the pupil facet mirror (13), said adjacent annular area (66) adjoining an external annular area (65).

17. Illumination optics according to any one of claims 2 to 16, **characterized in that** an interchangeable subunit (76) illuminates two opposite external boundary areas (78, 79) of the pupil facet mirror, said boundary areas (78, 79) having the shape of a pitch circle or a segment.

18. Illumination optics according to any one of claims 2 to 17, **characterized in that** an interchangeable subunit (77) illuminates two opposite adjacent boundary areas (80, 81) of the pupil facet mirror (13), said adjacent boundary areas (80, 81) having the shape of a pitch circle or a segment and adjoining the external boundary areas (78, 79) of the pupil facet mirror.

19. Illumination optics according to any one of claims 2 to 18, **characterized in that** an interchangeable subunit (69) illuminates opposite areas (71, 72) adjoining the central area (31).

20. Illumination system having
- an illumination optics according to any one of claims 1 to 19,
- an EUV light source (7).

21. Projection exposure apparatus (1) having
- an illumination system according to claim 20,
- a projection optics (18) for imaging the illumination field in an image field of an image plane (5).

22. Method of manufacturing a microstructured element by means of the following process steps:
- provision of a projection exposure apparatus according to claim 21,
- provision of a substrate (4) to at least part of which a layer of a light-sensitive material is applied,
- provision of a mask or a reticle (2) provided with structures to be imaged,
- projection of at least a part of the reticle (2) to an area of the light-sensitive layer by means of the projection exposure apparatus (1).

23. Method according to claim 22 comprising the following steps:
- implementation of the facet mirror of the illumination optics of the projection exposure apparatus in a first configuration of subunits during a first projection step,
- interchange of one of the subunits of the facet mirror by an interchangeable subunit so as to create a second configuration of subunits of the facet mirror,
- projection of at least a part of the reticle to an area of the light-sensitive layer by means of the projection exposure apparatus.

24. Method according to claim 23 where at least two subunits of the facet mirror are interchanged with interchangeable subunits for creating the second configuration.

## Revendications

1. Optique d'éclairage pour la microlithographie de projection EUV pour l'éclairage d'un champ d'éclairage dans un plan de réticule (3) avec un rayonnement EUV (8),
- avec au moins un miroir à facettes (10 ; 48 ; 67 ; 82) avec une pluralité de facettes (11) pour la génération d'un réglage d'éclairage défini pour l'éclairage et l'illumination du champ d'éclairage, les facettes (11) étant associées respectivement à des faisceaux partiels du rayonnement EUV (8),
- le miroir à facettes (10 ; 48 ; 67 ; 82) étant divisé en sous-unités (28, 29 ; 49, 50, 51 ; 49, 57, 58 ; 68, 69, 70 ; 68, 76, 77 ; 83, 84, 85 ; 83, 87, 88) qui de leurs côtés sont structurées en groupes de facettes (19, 25, 26),
l'optique d'éclairage (6) présentant un dispositif interchangeable (44 ; 56 ; 75 ; 86) pour le remplacement d'au moins l'une des sous-unités (29 ; 50, 51 ; 69, 70 ; 84, 85) du miroir à facettes (10 ; 48 ; 67 ; 82) par au moins une sous-unité interchangeable (57, 58 ; 69, 70 ; 84, 85).

2. Optique d'éclairage selon la revendication 1, **caractérisé en ce que**
- il s'agit pour l'au moins un miroir à facettes (10 ; 48 ; 67 ; 82) d'un miroir à facettes de champ avec une pluralité de facettes de champ (11) pour la génération de sources de lumière secondaires,
- un miroir à facettes de pupille (13) étant présent dans la zone d'au moins quelques sources de lumière secondaires générées par le miroir à facettes de champ (10 ; 48 ; 67 ; 82) avec une pluralité de facettes de pupille qui sont sollicitées par les facettes de champ qui leur sont associées, par un rayonnement EUV (8),
- le miroir à facettes de pupille (13) étant une partie d'un dispositif optique (15) qui représente le miroir à facettes de champ (10 ; 48 ; 67 ; 82) dans le plan de réticule.

3. Optique d'éclairage selon la revendication 2, **caractérisée en ce que** les facettes de champ (11) du miroir à facettes de champ (10 ; 48 ; 67 ; 82) sont orientées de sorte qu'une sous-unité (19, 25, 26) du miroir à facettes de champ (10 ; 48 ; 67 ; 82) éclaire des facettes de pupille (14) qui sont disposées dans une petite zone partielle (31, 32, 47 ; 31, 54, 55, 65, 66 ; 31, 71, 72, 73, 74, 78, 79, 80, 81) du miroir à facettes de pupille (13) par rapport à l'ouverture entière du miroir à facettes de pupille (13).

4. Optique d'éclairage selon l'une quelconque des revendications 1 à 3, **caractérisée en ce que** le dispositif interchangeable (44 ; 56 ; 75 ; 86) présente
- un entraînement de remplacement (44a ; 59) pour le déplacement de remplacement d'un support de sous-unité (59a) de telle sorte que dans le miroir à facettes de champ (10 ; 48 ; 67 ; 82), il soit passé d'une sous-unité à une autre (50, 51, 57, 58 ; 69, 70, 76, 77 ; 84, 85, 87, 88),
- un entraînement de positionnement (36) pour le déplacement de positionnement d'un corps de base (33) d'une des sous-unités (29 ; 50, 51, 57, 58 ; 69, 70, 76, 77 ; 84, 85, 87, 88) du dispositif interchangeable (44 ; 56 ; 75 ; 86) entre une position de miroir, dans laquelle la sous-unité (29 ; 50, 51, 57, 58 ; 69, 70, 76, 77 ; 84, 85, 87, 88) se trouve en position dans le miroir à facettes de champ (10 ; 48 ; 67 ; 82) et une position neutre, dans laquelle un déplacement de remplacement du support de sous-unité (59a) est possible.

5. Optique d'éclairage selon la revendication 4, **caractérisée en ce que** l'entraînement de remplacement (44a ; 59) présente un entraînement de pivotement du support de sous-unité (59a) pour le déplacement de remplacement autour d'un axe de pivotement (44b).

6. Optique d'éclairage selon la revendication 5, **caractérisée en ce que** l'axe de pivotement (60) coïncide avec un axe central (60a) du miroir à facettes de champ (48 ; 67 ; 82).

7. Optique d'éclairage selon l'une quelconque des revendications 1 à 6, **caractérisée en ce que** le dispositif de remplacement (44 ; 56 ; 75 ; 86) présente un système de conduite de transport (61) pour un produit de refroidissement refroidissant les sous-unités (29 ; 50, 51, 57, 58 ; 69, 70, 76, 77 ; 84, 85, 87, 88) interchangeables, un tronçon de conduite (62) du système de conduite de transport (61) s'étendant le long de l'axe de pivotement (60).

8. Optique d'éclairage selon la revendication 7, **caractérisée en ce qu'**au moins un tronçon de conduite (63, 64) du système de conduite de transport (61) est réalisé de manière flexible.

9. Optique d'éclairage selon l'une quelconque des revendications 4 à 8, **caractérisée en ce que** l'entraînement de positionnement (36) présente un bras de levier (34) qui est articulé au niveau de son extrémité libre au corps de base (33) et peut être pivoté pour le déplacement de position de manière motorisée autour d'une articulation tournante (35).

10. Optique d'éclairage selon l'une quelconque des revendications 4 à 9, **caractérisée par** au moins une butée (43) pour la prescription définie de la position de miroir.

11. Optique d'éclairage selon l'une quelconque des revendications 4 à 10, **caractérisée par** au moins une unité d'encliquetage pour la fixation de la position de miroir.

12. Optique d'éclairage selon l'une quelconque des revendications 2 à 11, **caractérisée en ce qu'**au moins une zone partielle (32 ; 55 ; 73, 74) du miroir à facettes de pupille (13) et/ou du champ d'éclairage est éclairée par des sous-unités (28 ; 49 ; 68 ; 83) stationnaires, donc non interchangeables du miroir à facettes (10 ; 48 ; 67 ; 82).

13. Optique d'éclairage selon l'une quelconque des revendications 2 à 12, **caractérisée en ce qu'**une sous-unité interchangeable (29 ; 50 ; 70) éclaire une zone partielle centrale (31) du miroir à facettes de pupille (13).

14. Optique d'éclairage selon l'une quelconque des revendications 2 à 13, **caractérisée en ce qu'**une sous-unité interchangeable (51) éclaire une première zone partielle annulaire (54) autour d'une zone partielle centrale (31) du miroir à facettes de pupille (13).

15. Optique d'éclairage selon l'une quelconque des revendications 2 à 14, **caractérisée en ce qu'**une sous-unité interchangeable (29' ; 58) éclaire une zone partielle annulaire extérieure (47 ; 65) du miroir à facettes de pupille (13).

16. Optique d'éclairage selon l'une quelconque des revendications 2 à 15, **caractérisée en ce qu'**une sous-unité interchangeable (57) éclaire une zone partielle annulaire contiguë (66) du miroir à facettes de pupille (13) qui est contiguë à une zone partielle annulaire extérieure (65).

17. Optique d'éclairage selon l'une quelconque des revendications 2 à 16, **caractérisée en ce qu'**une sous-unité interchangeable (76) éclaire deux zones partielles de bord (78, 79) extérieures en forme de secteur ou de cercle primitif opposées l'une à l'autre du miroir à facettes de pupille (13).

18. Optique d'éclairage selon l'une quelconque des revendications 2 à 17, **caractérisée en ce qu'**une sous-unité interchangeable (77) éclaire deux zones partielles de bord contiguës (80, 81) en forme de secteur ou en forme de cercle primitif opposées l'une à l'autre du miroir à facettes de pupille (13) qui sont contiguës aux zones partielles de bord extérieures (78, 79) du miroir à facettes de pupille (13).

19. Optique d'éclairage selon l'une quelconque des revendications 2 à 18, **caractérisée en ce qu'**une sous-unité interchangeable (69) éclaire des zones partielles opposées (71, 72) qui sont contiguës à la zone partielle centrale (31).

20. Système d'éclairage avec
- une optique d'éclairage selon l'une quelconque des revendications 1 à 19,
- une source de lumière EUV (7).

21. Installation d'exposition par projection (1) avec
- un système d'éclairage selon la revendication 20,
- une optique de projection (18) pour la représentation du champ d'éclairage dans un champ d'image dans un plan d'image (5).

22. Procédé de fabrication d'un composant microstructuré avec les étapes de procédé suivantes :
- mise à disposition d'une installation d'exposition par projection selon la revendication 21,
- mise à disposition d'un substrat (4) sur lequel est appliquée au moins en partie une couche d'un matériau photosensible,
- mise à disposition d'un masque ou d'un réticule (2) présentant des structures à représenter,
- projection au moins d'une partie du réticule (2) sur une zone de la couche photosensible avec l'installation d'exposition par projection (1).

23. Procédé selon la revendication 22 avec les étapes suivantes :
- utilisation du miroir à facettes de l'optique d'éclairage de l'installation d'exposition par projection dans une première configuration de sous-unités pendant une première étape de projection,
- remplacement de l'une des sous-unités du miroir à facettes par une sous-unité interchangeable pour la génération d'une seconde configuration de sous-unités du miroir à facettes,
- projection au moins d'une partie du réticule sur une zone de la couche photosensible avec l'installation d'exposition par projection.

24. Procédé selon la revendication 23, pour lequel au moins deux sous-unités du miroir à facettes sont remplacées par des sous-unités interchangeables pour la génération de la seconde configuration.
